(19) Europäisches Patentamt

European Patent Office

Office européen des brevets

(11) **EP 0 571 948 B1**

(12) **EUROPEAN PATENT SPECIFICATION**

(45) Date of publication and mention
of the grant of the patent:
**09.02.2000 Bulletin 2000/06**

(51) Int. Cl.⁷: **H01G 4/12**, H01L 27/115

(21) Application number: 93108423.0

(22) Date of filing: **25.05.1993**

(54) **Donor doped perovskites for thin film dielectrics**

Donatoren-dotierte Perovskite für Dünnfilm-Dielektrika

Perovskites dopés en donneurs pour couche mince diélectrique

(84) Designated Contracting States:
**DE FR GB IT**

(30) Priority: **29.05.1992 US 891560**

(43) Date of publication of application:
**01.12.1993 Bulletin 1993/48**

(73) Proprietor:
**TEXAS INSTRUMENTS INCORPORATED
Dallas Texas 75265 (US)**

(72) Inventors:
• **Summerfelt, Scott R.
Dallas, TX 75243 (US)**
• **Kulwicki, Bernard M.
Attleboro Falls, MA 02763 (US)**
• **Bertatan, Howard R.
Richardson, TX 75081 (US)**

(74) Representative:
**Schwepfinger, Karl-Heinz, Dipl.-Ing. et al
Prinz & Partner GbR
Manzingerweg 7
81241 München (DE)**

(56) References cited:
**EP-A- 0 431 671          EP-A- 0 469 934
EP-A- 0 503 565          EP-A- 0 504 756
DE-A- 3 915 339**

• **IEEE TRANSACTIONS ON PARTS, HYBRIDS
AND PACKAGING vol. 13, no. 2, June 1977, NEW
YORK US page 174 TOSHINORI NOZAWA ET AL.
'Stability of BaTiO3 Ceramics Doped with Dy for
High-Voltage Capacitor Use'**

## Description

### Field of the Invention

This invention relates to a method of forming a thin film dielectric, in particular for the fabrication of capacitors such as those in dynamic random access memory devices and to an integrated circuit device containing a thin film dielectric formed by this method.

### Background of the Invention

Without limiting the scope of the invention, its background is described in connection with current methods of forming thin film capacitors as an example.

Heretofore, in this field, thin film capacitors such as those in DRAMs have used $SiO_2$ or $Si_3N_4$ as the dielectric material. As the density of integrated circuits (number of devices per square centimeter) increases, the capacitors which store electrical charge in each DRAM memory device must decrease in size while maintaining approximately the same capacitance. Referring to the following equation, C is the capacitance of a planar capacitor, $\varepsilon$ is the dielectric constant, $\varepsilon_0$ is the dielectric permittivity of free space, A is the area, and d is the thickness of the dielectric.

$$C = \frac{\varepsilon \varepsilon_0 A}{d}$$

It is seen that the capacitance is directly proportional to the dielectric constant and inversely proportional to the thickness. Therefore, to build smaller capacitors while maintaining the same capacitance, one must increase $\varepsilon$ and/or decrease the dielectric thickness.

One method of allowing a decrease in capacitor area is to make use of materials with a much higher dielectric constant than $SiO_2$ or $Si_3N_4$. The dielectric constant for both of these materials is less than ten. An important class of high dielectric constant materials is the perovskites (e.g. $BaTiO_3$ and $SrTiO_3$). The dielectric constants of these materials may be as high as 10,000 when they are fabricated as bulk ceramics. To be used in the manufacture of miniature capacitors, these materials must be formed in thin films in a way that preserves their high dielectric constants relative to that of $SiO_3$.

EP-A-0 431 671 discloses a method of producing a ceramic body of a dielectric material on the basis of barium titanate. The ceramic body is manufactured from powdered materials by hot-pressing. This document reports that the addition of donor and acceptor material leads to a decrease of the dielectric constant, the decrease being the larger the more materials are added. It also reports that the dielectric constant of $BaTiO_3$ is maximal at a grain size between .7 and 1 μm and decreases rapidly with increasing grain size.

Intermediate document EP 0 503 565 A2 shows adding small amounts (e.g., 0.02 - 0.1 % by weight) of CuO to $BaTiO_3$ type compounds (e.g., $BaTiO_3$ + $SrTiO_3$ + $BaZrO_3$ + $PbTiO_3$ + $LaTiO_3$ + $CeO_2$) to lower the loss tangent when used for capacitor dielectrics.

DE-A-39 15 339 describes a dielectric which is made from a mixture of $BaTiO_3$, $Ba_{0.7}Sr_{0.3}TiO_3$, $Ta_2O_5$ and CoO.

### Summary of the Invention

This invention as defined in the appending claims, is a method for increasing the dielectric constant of perovskite materials. The perovskite materials are (1) any material exhibiting the well-known perovskite crystal structure, typified by $CaTiO_3$; and (2) compounds with structures which can be derived from the ideal cubic perovskite structure by way of small lattice distortions or omission of some of the atoms. Many perovskites have the chemical formula $ABO_3$, where A is one or more monovalent, divalent or trivalent elements, B is one or more pentavalent, tetravalent, trivalent or divalent elements.

It has been discovered that current methods of forming thin films of perovskite materials generally do not preserve the beneficial porperties that these materials exhibit in bulk ceramic form. In particular, the dielectric constants of current thin films of these materials do not approach those of perovskite materials fabricated as bulk ceramics. In addition, if these materials are to be used in the thin film capacitors which make up memory devices, they must also exhibit small leakage current at high electric fields and have small loss tangents. The electrical, chemical, and mechanical properties must be fairly uniform over the operating temperature range of the device.

Preserving the high dielectric constants exhibited by the bulk ceramic forms of perovskite materials in thin film form is difficult. It has been discovered that the dielectric constant of these materials generally decreases with decreasing grain size. The grain size in bulk ceramics is generally 1 to 20 micrometers (μm) while the grain size in a thin film is usually similar to the film thickness, generally 0.02 to 0.20 μm. For example, the range of dielectric constants observed in bulk ceramic barium titanate ($BaTiO_3$, hereafter referred to as BT) or barium strontium titanate (($Ba,Sr)TiO_3$, hereafter referred to as BST) is generally 1000 to 20,000 while the range of dielectric constants observed in thin films of these materials is only 100 to 600.

Other materials have also been considered for use in thin film capacitors. The dielectric constants of some materials, such as $(Pb,La)(Zr,Ti)O_3$ and $Pb(Mg,Nb)O_3$, do not decrease as rapidly with decreasing grain size. These materials, however, contain PbO which is very reactive with many materials, is easily chemically reduced, has a large vapor pressure and readily poisons silicon devices. For these reasons, such materials are probably inappropriate candidates for use in the fabrication of integrated circuits.

Much of the past research in this area has endeavored to preserve the high dielectric constant of perovskites such as BT and BST in thin film form. It is known that depositing thin films in a way that maximizes the grain size in the film serves to maximize the dielectric constant. This can be done by keeping the temperature of the substrate onto which the perovskite film is deposited at a high temperature, because higher deposition temperatures usually produce larger grain sizes in the deposited film. Higher substrate temperatures, however, may cause damage to existing devices and structures already formed on the substrate. Generally, temperatures should be kept as low as possible. Current methods of depositing thin film perovskites with high dielectric constants are thus limited by the film thickness and the potential damage caused by elevating the substrate to high temperatures.

Generally, the dielectric constant of thin film perovskite materials in enhanced by doping. The invention described is a method defined by the features of claim 1. An improved dielectric material is formed by doping an intrinsic perovskite material having an intrinsic critical grain size with one or more donor dopants, then forming a layer of the donor doped perovskite material having an average grain size less than the intrinsic critical grain size whereby the dielectric constant of the layer is substantially greater than the dielectric constant of the intrinsic perovskite material with an average grain size similar to the average grain size of the layer. The critical grain size, as used herein, means the largest grain size such that the dielectric constant starts to rapidly decrease with decreasing grain sizes. The donor doped perovskite material is further doped with one or more acceptor dopants to form a donor-acceptor doped perovskite material whereby the resistivity is substantially increased and/or the loss tangent is substantially decreased. The intrinsic perovskite material has a chemical composition $ABO_3$, where A is one or more monovalent, divalent or trivalent elements, and B is one or more pentavalent, tetravalent, trivalent or divalent elements.

Structures containing this improved dielectric material include a layer of donor doped perovskite material with average grain size less than the intrinsic critical grain size formed on the surface of a substrate. Other structures include such a layer of donor doped material interposed between two electrically conducting layers.

The applications of the materials made by the method of this invention are many. The materials presented may find use in many structures used in semiconductor circuitry, such as capacitors, MOS transistors, pixels for electro-magnetic radiation detecting arrays, and electrooptic applications. Devices which exploit the piezoelectric properties of many of these materals will benefit from this invention.

The advantages of this invention include substantially increased dielectric constants for perovskite materials formed with grain sizes typically found in thin films. In addition, the resistivity is generally increased and the loss tangent is generally decreased by the methods presented. The invention also provides for improved uniformity of the dielectric constant with respect to temperature for perovskite materials in thin film form.

## Brief Description of the Drawings

The features believed characteristic of the invention are set forth in the appended claim. The invention itself, however, as well as advantages thereof, will be best understood by reference to the detailed description which follows, read in conjunction with the accompanying drawings.

In the drawings:

Figure 1 is a graph showing the variation of dielectric constant versus temperature for undoped barium titanate of various grain sizes.

Figure 2 is a graph showing the variation of dielectric constant versus temperature for undoped barium titanate of various grain sizes.

Figure 3 is a graph showing the variation of dielectric constant versus grain size for undoped barium titanate.

Figure 4 is a graph showing the variation of dielectric constant versus temperature for undoped barium strontium titanate at various grain sizes.

## Detailed Description of the Preferred Embodiments

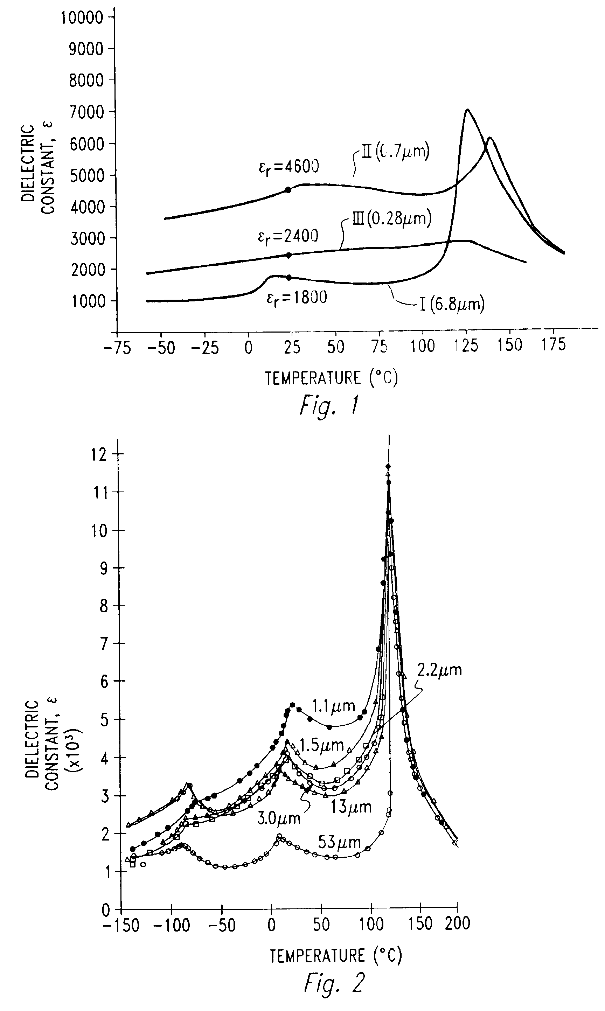

As shown in Figure 1, the dielectric constant of undoped barium titanate (BT) varies with temperature and grain size. For a grain size of 6.8 μm, the dielectric constant has a sharp peak at the Curie temperature, but is much less at other temperatures. As the grain size is decreased to 0.7 μm, the peak becomes less pronounced, the dielectric constant below the Curie temperature increases and varies less with temperature. At still smaller grain sizes, the dielectric constant decreases for all temperatures.

Referring to Figure 2, the same trend can be seen. At large grain sizes (i.e. 53 μm), the dielectric constant has a pronounced peak at the Curie temperature. As the grain size decreases, the dielectric constant below the Curie temperature increases. At 1.1 μm, for example, the dielectric constant is approximately three times higher at temperatures between 0 °C and Curie temperature.

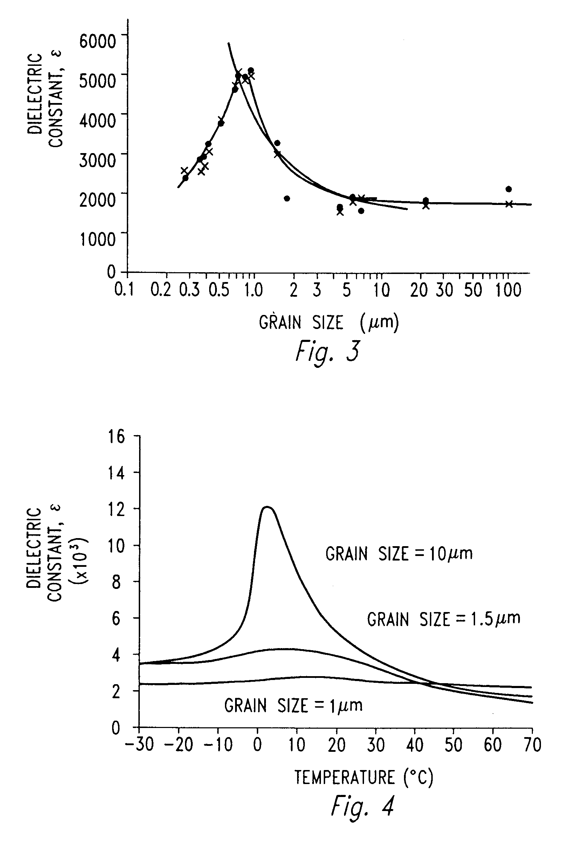

Referring to Figure 3, it is seen that there is a grain size at which the dielectric constant below the Curie temperature is at a maximum. Figure 3 shows measurements of the dielectric constant of barium titanate at both 25 °C and 70 °C (both of which are below the Curie temperature for that material). Again, the critical grain size, as used herein, means the largest grain size such that the dielectric constant starts to rapidly decrease with decreasing grain sizes. The critical grain size for barium titanate is approximately 0.7 μm according to the data represented by Figure 3.

Past efforts in this field have attempted to maximize the dielectric constant of thin films by forming the films in a way that causes the grain size to approach the critical grain size. The instant invention increases the thin film dielectric constant by doping the perovskite material to reduce the critical grain size. Any technique which decreases the critical grain size will improve the dielectric constant at still smaller grain sizes for temperatures below the Curie temperature.

It has been found that donor dopants generally decrease the critical grain size of perovskite materials. Generally, an element or ion is a donor dopant if (1) it replaces an atom in the crystal lattice and has a greater number of valence electrons than the atom it replaces or (2) it exists interstitially and its outer electron shell is less than half full. Intermediate cases are uncertain and may be determined empirically. For example, some elements behave as donor dopants in (1) when their valence is the same as the atom replaced. Likewise, in (2) some elements behave as donor dopants when their valence shell is exactly half full.

It has also been found that acceptor dopants increase the resistivity of some perovskite materials. It has also been found that acceptor dopants decrease the loss tangent of some perovskite materials. Therefore, another aspect of this invention is acceptor co-doping of perovskite materials. Generally, an element or ion is an acceptor dopant if (1) it replaces an atom in the crystal lattice and has a lesser number of valence electrons than the atom it replaces or (2) it exists interstitially and its outer electron shell is more than half full. Intermediate cases are uncertain and may be determined empirically. For example, some elements behave as acceptor dopants in (1) when their valence is the same as the atom replaced. Likewise, in (2) some elements behave as acceptor dopants when their valence shell is exactly half full.

A dopant is a species which is intentionally introduced into an intrinsic material in order to produce some effect. Unintentional impurities which exist in concentrations below approximately 0.1 mole percent are not generally considered dopants. Accordingly, in the context of this invention, an intrinsic perovskite material is a perovskite material in which impurities which behave as donor or acceptor dopants, if present, exist at concentrations below approximately 0.1 mole percent. Similarly, an intrinsic critical grain size is the critical grain size of an intrinsic perovskite material.

The nominal compositional formula for the preferred embodiment material is given as

$$(Ba_a, Sr_b, Ca_c)_{1-x}D_xTi_{1-y}A_yO_3$$

where D comprises a trivalent donor ion (e.g., Bi, Sb, Y, La, Ce, Pr, Nd, Sm, Gd, Tb, Dy, Ho, and Er or a combination thereof) and A comprises a trivalent acceptor ion (e.g., Co, Cu, Fe, Mn, Ru, Al, Ga, Sc, U, In, Ni, and Yb or a combination thereof) or a divalent acceptor ion (e.g., Mg). It is noted that both trivalent and divalent acceptor ions reside on the Ti sub-lattice. The values for the compositional ratios are given in Table 1.

Table 1

| Variable | Minimum | Maximum | Preferred |
|----------|---------|---------|-----------|
| a | 0.55 | 0.75 | 0.6 |
| b | 0.25 | 0.40 | 0.3 |
| c | 0.00 | 0.20 | 0.1 |
| x | 0.003 | 0.030 | .005 to .010 |
| y | 0.001 | 0.010 | .001 to .002 |

Of course, the sum of a, b, and c will be one (i.e., $a + b + c = 1$).

The nominal compositional formula for a second preferred embodiment material is given as

$$(Ba_a, Sr_b, Ca_c)Ti_{1-x-y}D_xA_yO_3$$

where D comprises a pentavalent donor ion (e.g., Nb, Ta or a combination thereof) and A comprises a trivalent or divalent acceptor ion (e.g., Co, Cu, Fe, Mn, Ru, Al, Ga, Mg, Sc, U, In, Ni, and Yb or a combination thereof). The values for the compositional ratios given in Table 1 still apply.

The nominal compositional formula for a third preferred embodiment material is given as

$$(Ba_a, Sr_b, Ca_c)_{1-x-y}D_xA_yTiO_3$$

where D comprises a trivalent donor ion (e.g., Bi, Sb, Y, La, Ce, Pr, Nd, Sm, Gd, Tb, Dy, Ho, and Er or a combination thereof) and A comprises a univalent acceptor ion (e.g., K, Na or a combination thereof). Once again, the values for the compositional ratios given in Table 1 apply.

The nominal compositional formula for a fourth preferred embodiment material is given as

$$(Ba_a, Sr_b, Ca_c)_{1-y}A_yTi_{1-x}D_xO_3$$

where D comprises a pentavalent donor ion (e.g., Nb, Ta, or a combination thereof) and A comprises a univalent acceptor ion (e.g., K, Na or a combination thereof). Yet once again, the values for the compositional ratios given in Table 1 apply.

It is noted that the preceding formulas for the four listed embodiments do not comprehend a balance of electrical charge if x and y are not equal. Since x and y are generally different (usually x > y), charge compensation must occur by formation of ionic vacancies on the Ba and/or the Ti sub-lattice(s). For the first embodiment example (i.e., trivalent donors on the Ba-site and trivalent acceptors on the Ti-site), assuming that x > y and compensation occurs on the Ba sub-lattice, the formula taking into account charge compensation would be:

$$[(Ba_a,Sr_b,Ca_c)_{1-x}D_xV_{(x-y)/2}][Ti_{1-y}A_y]O_3$$

since the difference in ionic charge substitution is (x-y) and one barium vacancy (V) can compensate a charge difference of 2 (Ba has a valence of 2). If the compensation occurred on the Ti site, (x-y)/4 vacancies would be required. In the present invention, it is typically desired that x > y, otherwise compensation could occur on the oxygen sub-lattice.

It can be seen that including the charge compensation leads to a plethora of different formulas, depending on the assumptions. It is therefore assumed that the nominal formulas given for the first four preferred embodiments encompass the variations which can be achieved to obtain charge compensation as described herein.

In an experiment, material with the nominal composition

$$(Ba_{0.66},Sr_{0.34})_{0.99}Dy_{0.01}Ti_{0.999}Mn_{0.001}O_3$$

was prepared. The material was made by combining constituents in a solution, then the solution was calcined in bulk, ground, pressed, then sintered. The resulting ceramic density was at least 95% of theoretical density. The ceramic material was then mechanically polished and thinned to 254 μm (10 mil) thickness. Metallization was applied to form test capacitors.

The average grain size of this material was 0.5 μm as measured by the line intercept method. The peak dielectric constant (the dielectric constant at the Curie temperature) was greater than 10,000, and varied rapidly with respect to temperature. This behavior indicates that the critical grain size of this material is less than 0.5 μm.

A few preferred embodiments have been described in detail hereinabove. It is to be understood that the scope of the invention also comprehends embodiments different from those described, yet within the scope of the claims. Other compounds not explicitly mentioned above are expected to benefit from the effects of donor doping. $(Sr,Pb)TiO_3$, for example, is an intrinsic perovskite material which may find considerable use in the electronics industry and which would benefit from donor doping.

Internal and external connections to devices fabricated with this improved dielectric material may be ohmic, capacitive, direct or indirect, via intervening circuits or otherwise. Implementation is contemplated in discrete components or fully integrated circuits in silicon, gallium arsenide, or other electronic materials families.

While this invention has been described with reference to illustrative embodiments, this description is not intended to be construed in a limiting sense. Various modifications and combinations of the illustrative embodiments will be apparent to persons skilled in the art within the scope of the appended claims.

## Claims

1. A method of forming a dielectric material by substitution of elements in a perovskite material of the type $(Ba,Sr,Ca)TiO_3$, comprising:

   (a) with $0.003 \leq x \leq 0.03$, replacing a fraction x of the (Ba,Sr,Ca) with one or more trivalent elements from the group Bi, Sb, Y, La, Ce, Pr, Nd, Sm, Gd, Th, Dy, Ho, and Er or replacing a fraction x of the Ti with one or more pentavalent elements from the group consisting of Ta and Nb;
   (b) with $0.001 \leq y \leq 0.01$ and y < x, replacing a fraction y of the (Ba,Sr,Ca) with one or more monovalent elements from the group K and Na or replacing a fraction y of the Ti with one or more trivalent or divalent elements from the group consisting of Co, Cu, Fe, Mn, Ru, Al, Ga, Sc, U, In, Ni, Yb, and Mg; and
   (c) maintaining the average grain size of the dielectric material to less than 0.5 μm wherein the fraction of Ba in the (Ba,Sr,Ca) is in the range of 0.55 to 0.75, the fraction of Sr in the (Ba,Sr,Ca) is in the range of 0.25 to 0.40, and the fraction of Ca in the (Ba,Sr,Ca) is in the range of 0.00 to 0.20.

## Patentansprüche

1. Verfahren zum Bilden eines dielektrischen Materials durch Substitution von Elementen in einem Perowskitmaterial des Typs $(Ba,Sr,Ca)TiO_3$, bei dem

   (a) ein Bruchteil x des (Ba,Sr,Ca) mit einem oder mehreren dreiwertigen Elementen aus der aus Bi, Sb, Y, La, Ce, Pr, Nd, Sm, Gd, Th, Dy, Ho und Er bestehenden Gruppe ersetzt wird oder ein Bruchteil x des Ti mit einem oder mehreren fünfwertigen Elementen aus der aus Ta und Nb bestehenden Gruppe ersetzt wird, wobei $0,003 \leq x \leq 0,03$ gilt;
   (b) ein Bruchteil y des (Ba,Sr,Ca) mit einem oder mehreren einwertigen Elementen aus der aus K und Na bestehenden Gruppe ersetzt wird oder ein Bruchteil y des Ti mit einem oder mehreren dreiwertigen oder zweiwertigen Elementen aus der aus Co, Cu, Fe, Mn, Ru, Al, Ga, Sc, U, In, Ni, Yb und Mg bestehenden Gruppe ersetzt wird, wobei $0,001 \leq y \leq 0,01$ und $y < x$ gilt; und

(c) die durchschnittliche Korngröße des dielektrischen Materials kleiner als 0,5 μm gehalten wird, wobei der Bruchteil von Ba in dem (Ba,Sr,Ca) im Bereich von 0,55 bis 0,75, der Bruchteil von Sr in dem (Ba,Sr,Ca) im Bereich von 0,25 bis 0,40 und der Bruchteil von Ca in dem (Ba,Sr,Ca) im Bereich von 0,00 bis 0,20 liegt.

## Revendications

1. Procédé pour former un matériau diélectrique par substitution d'éléments dans un matériau pérovskite du type (Ba, Sr, Ca) TiO3, comprenant :

  a) avec $0.003 \leq x \leq 0.03$, le remplacement d'une fraction x de (Ba, Sr, Ca) avec au moins un élément trivalent pris dans le groupe d'éléments Bi, Sb, Y, La, Ce, Pr, Nd, Sm, Gd, Th, Dy, Ho et Er ou le remplacement d'une fraction x de Ti avec au moins un élément pentavalent pris dans le groupe d'éléments constitué de Ta et Nb;

  b) avec $0.001 \leq y \leq 0.01$ et $y < x$, le remplacement d'une fraction y de (Ba, Sr, Ca) avec au moins un élément monovalent pris dans le groupe d'éléments constitué de K et Na ou le remplacement d'une fraction y de Ti avec au moins un élément trivalent ou divalent pris dans le groupe d'éléments constitué de Co, Cu, Fe, Mn, Ru, Al, Ga, Sc, U, In, Ni, Yb et Mg ;et

  c) le maintien de la taille de grain moyenne du matériau diélectrique à une valeur inférieure à 0,5 μm, dans lequel la fraction de Ba dans le (Ba, Sr, Ca) est comprise entre 0,55 et 0,75, la fraction de Sr dans le (Ba, Sr, Ca) est comprise entre 0,25 et 0,40 et la fraction de Ca dans le (Ba, Sr, Ca) est comprise entre 0,00 et 0,20.

Fig. 1

Fig. 2

Fig. 3

Fig. 4